# EUROPEAN PATENT APPLICATION

(11) **EP 2 244 361 A2**
(43) Date of publication of application: **27.10.2010**
(21) Application number: 10159187.3
(22) Date of filing: 07.04.2010
(51) Int. Cl.: H02K 9/04

(54) **Electric drive**

(30) Priority: 21.04.2009 FI 20095436
(71) Applicant: ABB Oy, 00380 Helsinki (FI)
(72) Inventor: Silvennoinen, Mika, 02610 Espoo (FI); Vartiainen, Mika, 02750 Espoo (FI)
(74) Representative: Holmström, Stefan Mikael

(57) **Abstract**

The present invention relates to an electric drive (1) comprising at least a choke unit (2), a power step unit (3), and a capacitor unit (4) for implementing power supply to an electricity-consuming device, and further comprising a cooling arrangement for cooling the choke unit (2), the power step unit (3), and the capacitor unit (4). In order to implement an advantageous and efficient cooling arrangement, the choke unit (2), the power step unit (3), and the capacitor unit (4) are distributed into at least two separate and separately coolable entities, and the cooling arrangement comprises parallel cooling apparatuses (5, 6, 7) for cooling the at least two separate and separately coolable entities.

## Description

### FIELD OF THE INVENTION

The present invention relates to an electric drive for implementing power supply to an electricity-consuming device, and particularly to a solution for ensuring sufficient cooling for an electric drive.

### DESCRIPTION OF PRIOR ART

An electric drive includes many components which, when being used, need to be cooled down in order to prevent the temperature of the electric drive from rising excessively. Such parts include, for instance, a choke unit, a power step unit, and a capacitor unit.

In a known solution, an electric drive comprises a cooling arrangement for cooling a choke unit, a power step unit, and a capacitor unit. In this solution, cooling air is sucked from outside the electric drive to a fan which blows cooling air to a flow channel through the choke unit, the power step unit, and the capacitor unit which are arranged successively in a flow direction.

A drawback of the above-mentioned known solution is providing a sufficient cooling capacity. In order to provide a sufficient cooling flow, a fan has to be high-powered because of a significant counterpressure in the flow channel. However, such a high-powered fan is noisy and expensive and, in order to operate, it requires a high-powered power feed unit which itself causes losses and costs.

On account of the aforementioned reasons, it may happen that sufficient efforts are not made for the cooling arrangement but, contrariwise, the amount of power to be drawn from the electric drive is limited to a level at which the heat load generated may be managed by a more inexpensive and less high-powered cooling arrangement.

### SUMMARY OF THE INVENTION

An object of the present invention is to solve the above-described problem and provide a solution which enables an inexpensive and efficient cooling arrangement to be implemented in an electric drive so that the existing power of an electric drive may be utilized as efficiently as possible. This object is achieved by an electric drive as claimed in the independent claim 1.

According to the invention, a choke unit, a power step unit, and a capacitor unit in need of cooling are distributed into at least two separate and separately coolable entities. Parallel cooling apparatuses of the cooling arrangement enable the entities to be cooled separately. This results in an electric drive comprising parallel cooled entities which may be cooled by more low-power cooling apparatuses, e.g. more low-power fans, which enable the cooling to be implemented in an inexpensive manner. Since the entities may be cooled separately precisely to the extent necessary, the power of the electric drive may be utilized in its entirety with no increase in the manufacture costs and with no risk of overheating.

Preferred embodiments of the electric drive according to the invention are disclosed in the dependent claims.

### BRIEF DESCRIPTION OF THE FIGURES

In the following, the invention is described in closer detail by way of example and with reference to the accompanying figures, in which
Figure 1 shows a first embodiment of an electric drive,
Figure 2 shows a second embodiment of an electric drive,
Figure 3 shows a third embodiment of an electric drive, and
Figure 4 shows a fourth embodiment of an electric drive.

### DESCRIPTION OF AT LEAST ONE EMBODIMENT

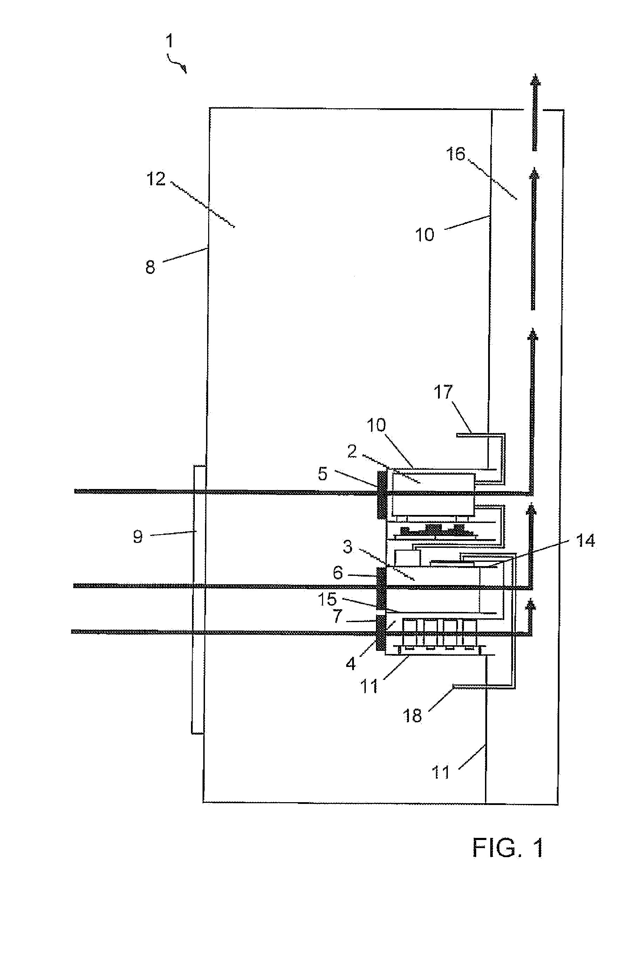

Figure 1 shows a first embodiment of an electric drive 1. The electric drive 1 enables power supply to an electricity-consuming device to be implemented. Such a device may be e.g. a frequency converter which, by means of electric power available from an electrical power network, implements power supply to an electric motor such that the rotation speed and rotation direction of the electric motor are constantly as desired. For this purpose, the electric drive 1 set forth in Figure 1 comprises, for instance, a choke unit 2, a power step unit 3, and a capacitor unit 4.

In Figure 1, the choke unit 2, the power step unit 3, and the capacitor unit 4 are distributed such that each one is arranged in a separate and separately coolable entity of its own although, according to the invention, it will suffice that the particular parts are distributed into at least two separate and separately coolable entities. A cooling arrangement of the electric drive 1 comprises parallel cooling apparatuses for cooling the entities to be cooled. In the embodiment of Figure 1, the cooling apparatuses comprise fans 5, 6, and 7, each one being responsible for cooling one entity by generating an air flow into the entity to be cooled.

The electric drive 1 of Figure 1 is housed inside an installation cabinet 8, in which case the fans 5, 6, and 7 generate a cooling air flow into the entities to be cooled by sucking air from outside through a door 9 of the installation cabinet 8. The separate and separately coolable entities are separated from other parts of the electric drive by means of intermediate walls 10 and 11. Thus, a space 12 is provided in the installation cabinet 8 of the electric drive 1, which may be utilized for parts of the electric drive which require no separate cooling.

The separate and separately coolable entities which include the choke unit 2, the power step unit 3, and the capacitor unit 4 are separated from one another by intermediate walls 14 and 15. The intermediate walls enable the electric drive 1 to be provided with parallel flow channels such that the entity which includes the choke unit 2 resides in a flow channel of its own, the entity which includes the power step unit 3 resides in a flow channel of its own, and the entity which includes the capacitor unit 4 resides in a flow channel of its own. In the example of Figure 1, the parallel flow channels coincide in the same discharge channel 16 as that used for conveying the cooling air flow away therefrom. Regardless of the common discharge channel 16, the intermediate walls 14 and 15 prevent warm air from moving freely from one entity to another, which means that it will suffice for each entity to arrange a cooling apparatus whose capacity suffices to cool the particular entity only.

In the embodiment of Figure 1, inlet connectors 17 and output connectors 18, through which the electric drive is coupled to the electrical power network and, correspondingly, to the electricity-consuming device to which the power supply is implemented by the electric drive, are arranged such that they reside at least partly in one or more entities to be cooled. In the example of Figure 1, the inlet connectors 17 reside partly in the same entity as the choke unit 2, while the output connectors 18 reside partly in the same entity as the capacitor unit 4. However, in order to facilitate the electrical connections, the inlet connectors 17 and, correspondingly, the output connectors 18 are shaped such that their ends, through which an electrical connection to the electrical power network and, correspondingly, to the electricity-consuming device is carried out, penetrate through the intermediate walls 10 and 11 into the space 12, wherein the electrical connection may be implemented by means of cables, for instance.

It has been set forth above by way of example that it is expressly the choke unit, the power step unit, and the capacitor unit that are in need of special attention when implementing a cooling solution. This, however, is only an example. In practice, the electric drive may also include other devices, such as brake choppers, which require efficient cooling and for which it is thus appropriate to arrange parallel cooling of their own. It is also feasible that the same electric drive employs more than one corresponding module, e.g. two capacitor units having parallel cooling of their own.

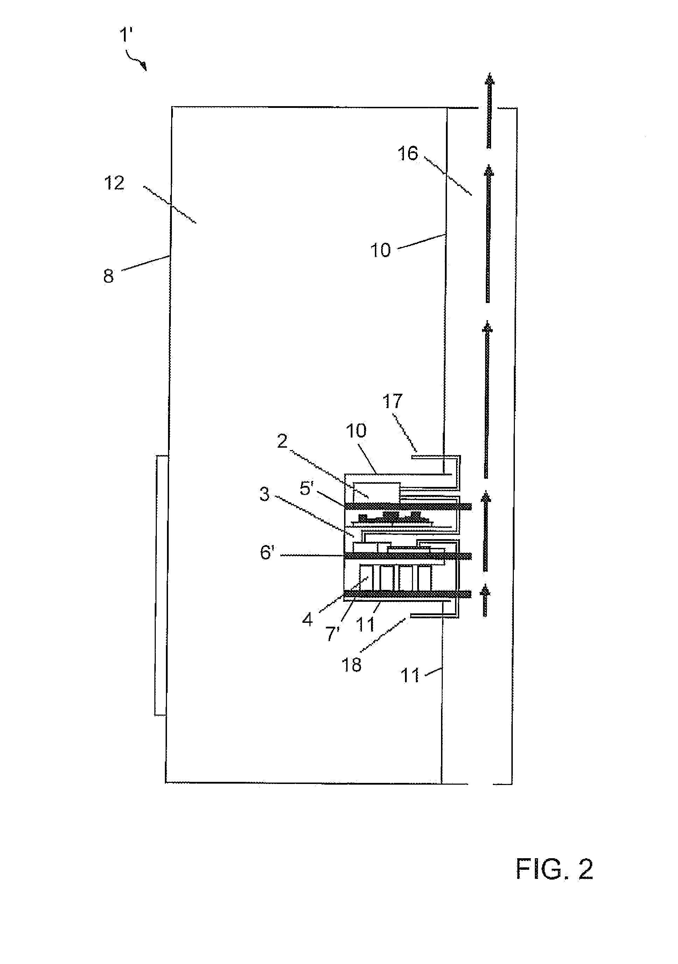

Figure 2 shows a second embodiment of an electric drive 1'. The embodiment of Figure 2 is very similar to the embodiment of Figure 1 so, in the following, the embodiment of Figure 2 will be described mainly by drawing attention to differences between these embodiments.

As distinct from Figure 1, in the case of Figure 2, the separate and separately coolable entities are not cooled by generating an air flow through the entities. Contrarily, in the embodiment of Figure 2, a thermosyphon element, i.e. a so-called heat-pipe element, is provided to penetrate into each entity. A thermosyphon element per se is a prior art heat exchanger which, in the example of Figure 2, is utilized for transferring heat away from the entity including the choke unit 2, the entity including the power step unit 3, and the entity including the capacitor unit 4. In order to implement this, first ends of the thermosyphon elements are correspondingly arranged to penetrate into the entity to be cooled, while their second ends are arranged in the discharge channel 16 through which a cooling air flow has been generated. The heat load generated at the first ends of the thermosyphon elements may thus be removed into the air flow through the second ends.

In a manner similar to that disclosed in the embodiment of Figure 1, intermediate walls may be arranged between the different entities in order to prevent a heat load from transferring from one entity to another.

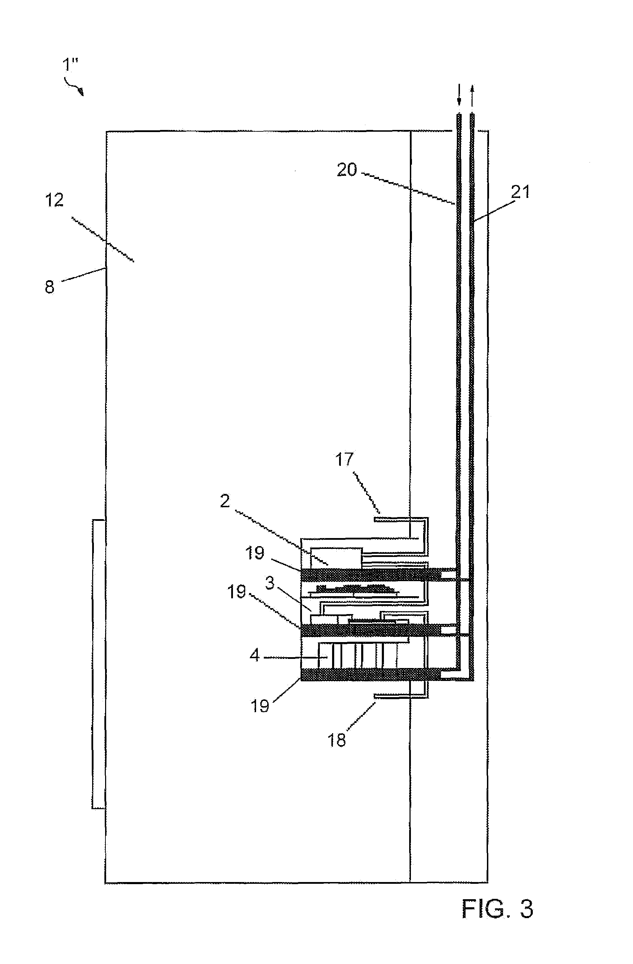

Figure 3 shows a third embodiment of an electric drive. The embodiment of Figure 3 is very similar to that of Figure 1 so, in the following, the embodiment of Figure 3 will be described mainly by drawing attention to differences between these embodiments.

As distinct from Figure 1, in the case of Figure 3, the separate and separately coolable entities are not cooled by generating an air flow through the entities. Contrarily, in the embodiment of Figure 3, a cooling element 19 is provided to penetrate into each entity, the cooling element 19 being connected with an inlet pipe 20 and with an outlet pipe 21 in order to generate a cooling fluid flow through a cooling channel of the cooling element. By shaping and dimensioning the cooling elements 19 in an individual manner, the choke unit 2, the power step unit 3, and the capacitor unit 4 may be provided with precisely as efficient cooling as necessary.

In a manner similar to that in the embodiment of Figure 1, intermediate walls may be arranged between the different entities in order to prevent a heat load from transferring from one entity to another.

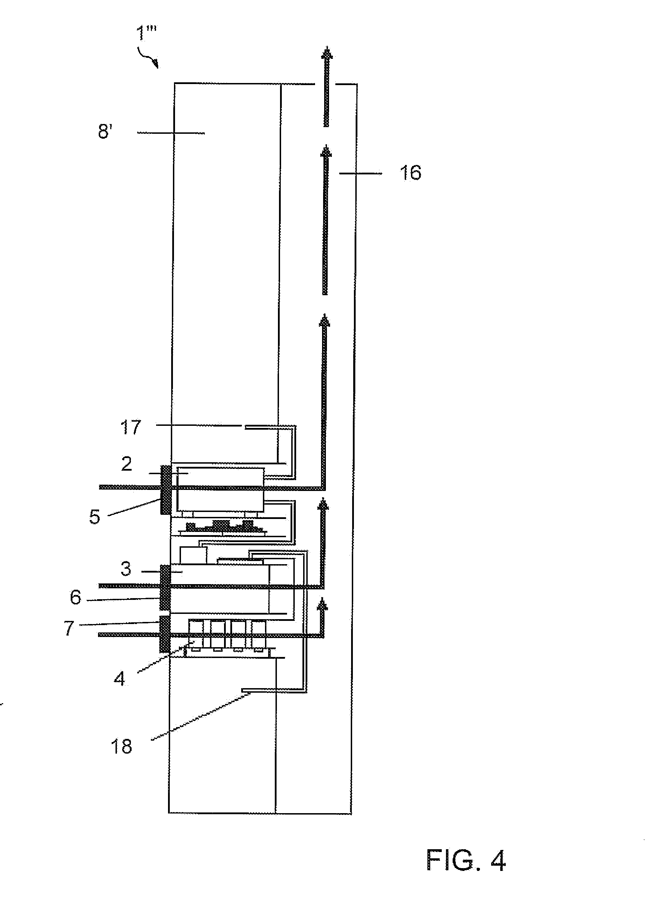

Figure 4 shows a fourth embodiment of an electric drive. The embodiment of Figure 4 is otherwise similar to that of Figure 1 but in the example of Figure 4, the depth of a cabinet 8' is smaller than in the case of Figure 1. Consequently, the structure of an electric drive 1"' differs from the embodiment of Figure 1 in that the fans 5, 6, and 7 are arranged in the door of the cabinet, and in this example they are arranged outside the door. This makes it possible to achieve the electric drive 1"' which, in a depth direction of the cabinet, may be implemented in a space-saving manner.

It has been shown above by way of example that the separately coolable entities of the electric drive are implemented such that they employ the same cooling solution, i.e. an air flow, a thermosyphon element or a cooling element. This, however, is only an example. In practice if, for instance, the cooling need varies in different entities, different cooling apparatuses may be mutually utilized in the different entities of the same electric drive, e.g. such that a first one is cooled by an air flow, a second one by a thermosyphon element, and a third one by a cooling element having a liquid cooling circulation.

It is to be appreciated that the above description and the related figures are only intended to illustrate the present invention. It will be apparent to a person skilled in the art that the invention may be also modified and altered in other ways without deviating from the scope of the claims.

## Claims

1. An electric drive (1, 1', 1 ", 1"') comprising at least a choke unit (2), a power step unit (3), and a capacitor unit (4) for implementing power supply to an electricity-consuming device, and further comprising a cooling arrangement for cooling the choke unit (2), the power step unit (3), and the capacitor unit (4), **characterized in that**
the choke unit (2), the power step unit (3), and the capacitor unit (4) are distributed into at least two separate and separately coolable entities, and
the cooling arrangement comprises parallel cooling apparatuses (5, 6, 7; 5', 6', 7'; 19) for cooling the at least two separate and separately coolable entities.

2. An electric drive (1, 1', 1", 1"') as claimed in claim 1, **characterized in that** the choke unit (2), the power step unit (3), and the capacitor unit (4) are distributed such that each one constitutes a separate and separately coolable entity of its own, and that the cooling arrangement comprises parallel cooling apparatuses (5, 6, 7; 5', 6', 7'; 19) for each separately coolable entity.

3. An electric drive (1, 1', 1", 1"') as claimed in claim 1 or 2, **characterized in that** the separate and separately coolable entities are separated from other parts of the electric drive (1, 1', 1 ", 1"') by means of intermediate walls (10, 11).

4. An electric drive (1, 1"') as claimed in any one of claims 1 to 3, **characterized in that** the choke unit (2), the power step unit (3), and the capacitor unit (4) are distributed into separately coolable entities by means of the intermediate walls (14, 15) which separate the entities from one another and which form a part of parallel flow channels of the cooling arrangement for generating a separate air flow for each entity to be cooled.

5. An electric drive (1, 1"') as claimed in claim 4, **characterized in that** a separate fan (5, 6, 7) is arranged for each separately coolable entity.

6. An electric drive (1, 1"') as claimed in claim 4, **characterized in that** the cooling arrangement comprises a common discharge channel (16) for discharging an air flow generated into the entities to be cooled from the entities to be cooled through the common discharge channel.

7. An electric drive (1') as claimed in any one of claims 1 to 3, **characterized in that** the cooling arrangement comprises for at least one entity a thermosyphon element (5', 6', 7') whose first end is arranged to penetrate into the at least one entity to be cooled, and whose second end is arranged, separate from the at least one entity to be cooled, in an air flow in order to convey a heat load from the entity to be cooled to the air flow.

8. An electric drive (1") as claimed in any one of claims 1 to 3, **characterized in that** the cooling arrangement comprises for at least one entity a cooling element (19) which is arranged in the at least one entity to be cooled and which is connected with an inlet pipe (20) and an outlet pipe (21) in order to provide a cooling fluid flow through a cooling channel of the cooling element.

9. An electric drive (1, 1', 1 ", 1"') as claimed in any one of the preceding claims, **characterized in that** inlet connectors (17) and outlet connectors (18) of the electric drive (1, 1', 1 ", 1"') are arranged at least partly in the one or more entities to be cooled.

10. An electric drive (1, 1', 1 ", 1"') as claimed in any one of the preceding claims, **characterized in that** the electric drive is housed inside an installation cabinet (8).
